# EUROPEAN PATENT APPLICATION

(11) **EP 0 555 575 A1**
(43) Date of publication of application: **18.08.1993**
(21) Application number: 92304176.8
(22) Date of filing: 08.05.1992
(51) Int. Cl.: H05K 3/00

(54) **Method and apparatus for machining printed circuit boards**

(30) Priority: 11.02.1992 US 834885
(71) Applicant: EXCELLON AUTOMATION, Torrance, California 90509 (US)
(72) Inventor: Watkinson, Robert James, California 90815 (US)
(74) Representative: Sommerville, John Henry

(57) **Abstract**

An apparatus and method are disclosed for efficiently lubricating printed circuit boards (16) which are being machined. A vacuum system (50) and a lubrication system (70) are employed on a drilling machine (10) having a spindle assembly (12) and an independently-movable pressure foot (26) wherein the vacuum system (50) and lubrication system (70) are each in fluid communication with a working area (42) defined by the interior of the pressure foot (26). A method for using the vacuum system (50) and the lubrication system (70) includes directing the pressure foot (26) against the workpieces (16) to create a fluid seal, creating a vacuum within the interior of the pressure foot (26), supplying lubricant (78) to the hole being drilled so that lubricant (78) accumulates only within the working area (42) and, finally, releasing the pressure foot (26) from engagement with the workpieces (16) to permit a flow of air into the interior of the pressure foot (26) thereby permitting used lubricant (90) and chips (92) to be evacuated through an exhaust conduit (54) and into a waste receptacle (56).

## Description

### Field of the Invention

The present invention relates generally to the machining of brittle sheet material and more specifically to an apparatus and method for providing continuous lubrication to ceramic and like material work pieces during machining operations.

### Background of the Invention

Currently, a variety of insulating board materials are used in the production of printed circuit boards (PCB's). Traditionally, dimensionally stable glass-based and cloth-based plastic laminates are used, although the most common are the low-cost phenolic paper laminates used in mostly consumer, but some commercial, applications. The use of higher radio frequencies (1-GHz range), or more rapid response digital circuitry, has required that Teflon glass be used as the laminate base. At still higher frequencies (above 3-GHz) a ceramic base material such as alumina is used due to its uniform dielectric or insulating properties. The ceramic materials used for insulating boards are generally classified as glass ceramics, which suggests the highly brittle nature of these materials. In addition to being brittle, the glass ceramics are very hard, sometimes exhibiting hardness characteristics typical of metals. As will be explained below, these characteristics do not lend themselves easily to the manufacture of PCB's.

Most PCB's support numerous electrical components, such as integrated circuits, on the insulating board itself. In order to maximize the efficient use of space, many of the components on the PCB are extremely small in size, thus providing a dense environment of components. Each of the components includes numerous electrical leads which extend from the components into the insulating board. As a result, the production of PCB's involves the drilling of a large number of holes into the insulating board in order to accommodate the numerous components and electrical leads. Due to the dense environment, the required hole sizes can be as small as 0.004 inches in more complex boards.

In addition to the holes for the electrical leads, other holes are also required to permit the secure mounting of the PCB itself to the inner structure of a host device. In many cases, literally thousands of holes may be required to enable the above-referenced assemblies to be made. In addition, the high density of components requires the utmost precision in the placement of the holes in the PCB's. All of the holes must be drilled cleanly and precisely due to the low tolerance requirements associated with dense circuitry layout. At the same time, effective machining speeds of more than one hole per second create physical challenges to effecting clean and accurate machining. As such, the machining of holes in the insulating board is a critical step in the manufacturing of PCB's.

While the majority of PCB's cost less than $100 as a finished product, in some applications, such as a "mother" board for a supercomputer, the finished PCB may cost up to $15,000. Thus, the importance of the machining operation can be appreciated. To better appreciate the drilling operation itself, particularly with respect to the machining of printed circuit boards, a description of a conventional drilling machine is provided below.

A conventional drilling machine which is used for drilling holes in a stack of PCB insulating boards includes one or more vertically-mounted spindle assemblies, each of which support a replaceable drill bit. A horizontal work table is also provided below the spindle assemblies for movably supporting one or more workpieces, e.g., insulating boards, thereon. Typically, up to three workpieces are stacked on the work table simultaneously in order to increase machining efficiency.

A spindle assembly consists of a spindle rotor which rotates about a vertical axis within a cylinder housed in a spindle housing. The cylinder reciprocates axially in the vertical direction in order to bring the rotating spindle rotor to the workpieces for drilling purposes. The spindle rotor supports a collet at the base of the rotor. The collet includes an adjustable split sleeve portion for "chucking" a drill bit securely within the collet. As the spindle rotor is lowered toward the work table, the drill bit is rotated to cause a hole to be drilled into a workpiece.

Surrounding the collet at the base of the spindle housing is an independently-movable annular collar, commonly referred to as a pressure foot. The pressure foot is configured to define, within its interior walls, a "working area" for the accumulation of drilling chips generated during the machining operation. The working area is sufficiently large to permit the cylinder, the spindle rotor and the drill bit to reciprocate vertically within the pressure foot. In addition, the pressure foot is movable vertically to engage the top of the workpieces in order to clamp the workpieces tightly against the work table. The clamping of the workpieces to the work table eliminates any undesired movement of the workpieces which would affect the accuracy of the machining operation.

In some drilling operations, it is desirable to maintain a sub-atmospheric pressure or vacuum within the working area in order to draw an air stream through the working area for the removal of the drilling chips as the drilling process progresses. However, when the pressure foot is pressed downwardly against the workpieces, the engagement of the bottom surface and the pressure foot and the top surface of the workpieces significantly restricts the flow of air into the working area from underneath the pressure foot. As such, it is necessary to provide a small vent port in the walls of the pressure foot in order to maintain an inward flow of air for the continuous removal of the chips.

For the most common type of insulating board material such as phenolic, the drilling operation is relatively simple due to the softness of the phenolic material. The drill bits used to bore the holes can be used repeatedly without the need for lubrication. However, with ceramic and like materials, the machining operation must be modified to accommodate their hard and brittle nature. With such materials, there is a significant heat buildup associated with the machining operation which, in the case of hole drilling, can result in the binding, breaking and excessive wear of the drill bit in the workpiece. This undesired result significantly influences the accuracy of the hole being drilled. Current techniques for drilling through stacks of ceramic boards include using extremely high-strength carbon- or diamond-tipped drill bits. Furthermore, some form of lubrication is applied in order to cool the drill bit and the workpiece during the drilling operation as well as to prevent binding or fracture of the drill bit in the workpiece.

In conventional drilling operations, for instance, the drilling of metal components, lubrication serves several functions, including cooling of the drill bit and workpiece as well as facilitating the drilling operation itself, i.e., preventing drill bit binding. In addition, with certain materials, oil-based lubricants act as rust inhibitors in preserving the component until the finished product is complete. Typically, lubrication is provided using one of three techniques. Some machinists maintain a spray can of lubricant within reach and periodically spray the workpiece and drill bit manually as required. In other cases, a system of automatically delivering lubricant to the workpiece is employed, either to effect periodic spraying of the lubricant or to effect the delivery of a continuous stream of lubricant directed at the workpiece and drill. While the latter has the disadvantage of requiring a collection system, the former sometimes results in the creation of a lubricant fog which is both annoying and unhealthy.

With regard to the machining of ceramic insulating boards, one method of lubrication involves immersing an entire stack of ceramic boards in a fluid bath of lubricant and drilling the boards while submerged. As expected, this process is cumbersome and requires extensive modifications to conventional drilling machines in order to accommodate the immersion bath. In addition, because rust inhibition is not desired or necessary with insulating boards, total immersion of the workpiece in lubricant is wasteful. However, with very small diameter drill bits and the need to apply drill strokes at a rapid rate, it is necessary to supply an ample amount of lubricant. Complicating the matter is the need to accommodate the accumulating chips produced during the drilling operation while still providing effective lubrication. Presently, no other effective lubrication techniques have been successfully developed beyond the immersion bath. Consequently, there is a need to provide effective lubrication to a machining operation including, amongst other processes, the drilling of stacks of ceramic insulating boards. In addition, there is a need to provide a means for lubrication which replaces the otherwise cumbersome immersion bath and which provides lubrication without the need for extensive modifications to present machining equipment. Finally, there is a need to effectively and efficiently confine the lubricant to the area of the workpiece being machined rather than over the entire workpiece.

### Summary of the Invention

The present invention permits efficient lubrication and removal of lubricant during machining operations while simultaneously confining the lubricant to a very small area on the workpieces being machined. The invention is particularly suited to the drilling of ceramic printed circuit boards where high tolerances in the size and location of the holes drilled must be maintained. In addition, with the present invention, little adaption is necessary to a conventional drilling machine which is described above. The apparatus of the present invention employs many features of the above-described drilling machine, including a vacuum system and a spindle assembly having a cylinder, rotor, pressure foot and collet. More importantly, the present invention further comprises a unique lubrication application system.

The pressure foot of the present invention differs from a conventional pressure foot to the extent that a concentric insert is provided at the base of the pressure foot. In addition, the vent port on the pressure foot is eliminated. The insert is a short sleeve which extends downwardly from the main portion of the pressure foot and includes a smooth bottom surface for sealed engagement with the workpieces. When the insert of the pressure foot is forcibly applied against the top surface of the workpieces, a fluid seal results between the bottom surface of the insert and the top surface of the workpieces, substantially precluding air flow therebetween. In addition, because the inner diameter of the pressure foot is only slightly larger than the outer diameter of the cylinder, the resulting air layer between the cylinder and the pressure foot is relatively thin, severely limiting the ability of air to flow therebetween. Thus, when a vacuum is applied to the working area, little or no air flows through the working area, providing a substantially static environment within the insert.

The vacuum system of the present invention includes a vacuum pump, a waste receptacle, and an exhaust conduit for evacuating the working area of any accumulating debris. The waste receptacle, which is in fluid communication with the vacuum pump and the exhaust conduit, receives and collects debris that accumulates during the drilling operation. The inlet end of the exhaust conduit is preferably secured to the pressure foot at a position above the insert in order to preserve the static environment within the insert when the insert is engaged with the workpieces.

The lubrication system of the present invention is in fluid communication with the insert and is adapted to selectively provide a continuous flow of lubricant into the insert and onto the drill bit and workpiece. The lubrication system includes a source of lubricant stored in a container, a lubrication pump for directing the lubricant into the working area, and a lubrication delivery conduit connecting the lubrication pump with the working area within the insert. With the present invention, lubricant is applied only within the working area, thus eliminating the escape of lubricant on the balance of the workpiece. In addition, no submersion bath is necessary, thus facilitating a retro-fitting procedure.

With the present invention, the pressure foot insert is sealably directed against the workpieces, thus clamping the workpieces against the work table and substantially preventing the flow of air into the working area at the point of engagement. If not already in operation, the vacuum pump is activated so as to create a vacuum within the working area. However, due to the fluid seal, substantially no air flow is permitted to flow through the insert. The minimal air flow entering the working area from between the pressure foot and the cylinder exits the exhaust conduit without affecting the static environment within the insert.

Following engagement of the pressure foot with the workpieces and activation of the vacuum system, the spindle assembly is then directed downwardly through the pressure foot to begin the drilling operation. Contemporaneously, a supply of lubricant is directed through the delivery conduit and into the insert so that the lubricant bathes the drill bit and hole during machining. Because air flow is substantially prevented through the insert, the lubricant and any drilling chips generated during the drilling operation accumulate within the insert for later disposal. This feature is advantageous because localized lubrication results only about the hole being drilled rather than over the entire workpiece.

When the hole is complete, the pressure foot is released from the workpieces so that the work table can be relocated to the next hole drilling position. Upon release of the pressure foot, a flow of air is drawn into the working area through the insert under the force of the vacuum, thereby entraining the lubricant and drilling chips and carrying them away through the exhaust conduit into the waste receptacle. In the preferred embodiment, where drilling strokes are performed sequentially at a rapid rate, the lubrication system is in continuous operation. Any lubricant supplied while the work table is in motion is immediately drawn out of the working area by the force of the vacuum.

With the present invention, effective supply and removal of lubricant is provided in a manner which limits lubrication to a small confined area. Thus, the present invention overcomes the drawbacks associated with machining ceramic, PCB insulating boards and is described in more detail below in reference to the following drawings.

### Brief Description of the Drawings

Figure 1 is a front view of the improved machining apparatus of the present invention showing a spindle assembly, a lubrication system and a vacuum system.

Figure 2 is a partial, cross-sectional view of the lower portion of the spindle assembly of Figure 1, showing a pressure foot and a drill bit engaging a stack of workpieces.

Figure 3 is the partial cross-sectional view of Figure 2, showing the drill bit and pressure foot positioned above the stack of workpieces to be machined.

### Detailed Description of the Invention

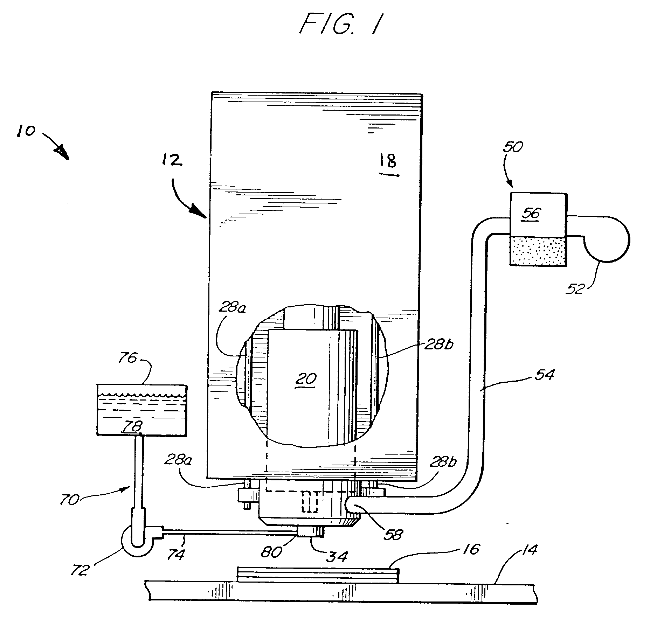

Reference is now made to the figures in which like components will be designated with like numerals throughout. Figure 1 shows a preferred embodiment of the improved machining apparatus which is a drilling machine 10 employing a vertically-oriented spindle assembly 12 and a horizontally-movable work table 14 upon which a stack of workpieces are supported for machining purposes. The stack of workpieces is, by example, a plurality of ceramic insulating boards 16 shown stacked below the spindle assembly 12. Typically, up to three insulating boards 16 are machined simultaneously in order to improve machining efficiency.

The spindle assembly 12 comprises a spindle housing 18 for supporting and enclosing a cylinder 20 which is axially movable in the vertical direction with respect to the spindle housing 18. The cylinder 20 encloses a rotor shaft (not shown) which is rotatable about a vertical axis and which supports a collet 22 positioned at its lower end. As with many conventional hand drills, the collet 22 of the present invention includes of a preferably-tapered, split sleeve portion which may be adjustably opened and closed to securely accept a machine tool, such as a drill bit (not shown), therein.

The spindle assembly 12 further includes a pressure foot 26 which is also movable axially in the vertical direction independently of the cylinder 20. Axial movement of the pressure foot 26 is caused by vertical movement of guides 28a and 28b. Both the cylinder 20 and the pressure foot 26 are driven by a leadscrew (not shown), positioned within the spindle housing 18.

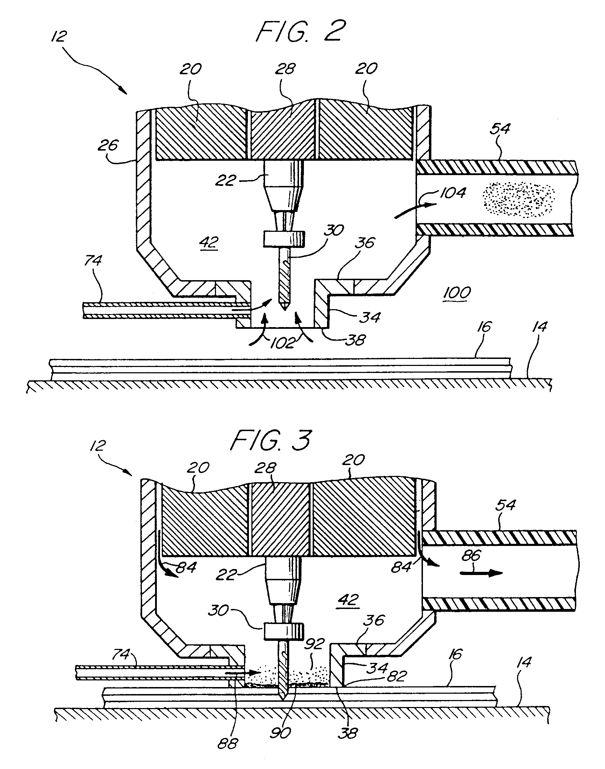

Referring momentarily to Figure 2, a close up of the cylinder 20, the collet 22 and the pressure foot 26 can be seen in greater detail. The rotor shaft 28 can also be seen extending through the cylinder 20 and directly supporting the collet 22 below. The pressure foot 26 is preferably annular in configuration and surrounds the collet 22 and the drill bit 30, while permitting rotation and axial movement of each. At the base of the pressure foot 26 is a concentrically-positioned insert 34 through which the drill bit 30 extends during the drilling operation. The insert 34 consists preferably of a short sleeve having a collar 36 which can be mechanically fastened to the main body of the pressure foot 26, preferably via a threaded connection. The insert 34 also includes a smooth flat surface 38 at its base for sealed engagement with the ceramic insulating boards 16. Still referring to Figure 2, it can also be seen that a working area 42 is defined by the interior walls of the pressure foot 26 and insert 34 through which the collet 22 and the drill bit 30 extend. The function of the working area 42 is described further below.

During operation of the drilling apparatus, the pressure foot is reciprocated repeatedly, thus alternatively clamping and releasing the workpieces from the worktable. Due to its repeated engagement with the workpieces 16, the insert 34 tends to wear down. By providing an insert 34 which is discrete from the main body of the pressure foot 26, a worn insert may be replaced relatively inexpensively. However, if desired, the pressure foot 26 and insert 34 may be formed as a unitary piece. In either case, the pressure foot 26 and insert 34 are preferably cast and machined from aluminum.

Referring back to Figure 1, it can be seen that the present invention also comprises a vacuum system 50. The vacuum system 50 itself comprises a conventional vacuum pump 52, an exhaust conduit 54 and a waste receptacle 56 preferably positioned therebetween. The vacuum pump 52 is in fluid communication with the waste receptacle 56 to maintain a vacuum therein for purposes of receiving and collecting debris generated during the drilling operation. The waste receptacle 56 is a rigid container of conventional configuration and construction and is in fluid communication with the working area (Figure 2) through the exhaust conduit 54 at connection 58.

While the vacuum pump 52 is operating, the working area is maintained under a continuous sub-atmospheric pressure or vacuum, as will be discussed further below. In the preferred embodiment, the working area is maintained during operation under a vacuum pressure of about 20 in. H₂0. However, one skilled in the art will appreciate that this pressure can be varied depending upon the particular configuration of the drilling machine and the particular demands placed on the machine during operation.

In addition to the vacuum system 50, the present invention also includes a lubrication system 70 which comprises a conventional, positive-pressure lubricant pump 72, a lubricant supply conduit 74, and a lubricant reservoir 76 for storing a lubricant 78, such as a water-oil emulsion, therein. The lubricant reservoir 76 is preferably a rigid container of conventional configuration and construction and is in fluid communication with the insert 34 through the lubricant pump 72 and the supply conduit 74 at connection 80. Operation of the lubricant pump 72 causes the lubricant 78 to be delivered through the lubricant conduit 74 and into the working area (not shown) of the insert 34. To ensure a leak-free environment, the supply conduit 74 is connected to the insert 34 in a fluid-tight manner. With the present invention, it is preferable to supply the lubricant 78 at a positive pressure of about 20 pounds/in². However, one skilled in the art will appreciate that this pressure can be varied depending upon the particular configuration of the drilling machine and the particular demands placed on the machine during operation.

With ceramic workpieces, a water-oil emulsion is a preferable lubricant and consists of a mixture of oil and water at a ratio of about 1 part oil to 12 parts water by volume. It should be noted, however, that while oil-emulsified water is preferable, other lubricants may be used depending upon the particular needs of the user. During the drilling operation, a flow of lubricant can be directed into the working area 42 so as to provide lubrication local to the hole being drilled.

Referring now to Figure 2, the apparatus and method of the present invention may be explained in greater detail. There the insert 34 of the pressure foot 26 is shown pressing downwardly on a top surface of the workpieces 16. Because of the smooth bottom surface 38 of the insert 34, a fluid seal is created at the junction 82 therebetween, thus substantially preventing air flow through the insert 34. It should be noted that, typically, the top (not shown) of the pressure foot 26 is not fluidly sealed against the bottom of the spindle housing 18 (Figure 1). As such, a small flow of ambient air will enter the working area 42 under the force of the vacuum from in between the cylinder 20 and the pressure foot 26, as shown by arrows 84. Depending upon the relative size of the cylinder 20 with respect to the pressure foot 26, the amount of air flow represented by arrows 84 is preferably minimal, thus effecting the vacuum pressure within the working area 42 only negligibly. The air flow represented by arrows 84 is drawn through the working area 42 and directly into the exhaust conduit 54, as shown by arrow 86, without disturbing the portion of the working area 42 within the insert 34. When the insert 34 is in sealed engagement with the workpieces 16, as shown in Figure 2, the air within the insert 34 remains relatively static so that debris generated during the drilling operation, e.g., spent lubricant and drilling chips, will accumulate within the insert working area 42 for later disposal.

Still referring to Figure 2, the method of operating the present invention can be described in greater detail. When it is desired to drill a hole into the stack of workpieces 16, the pressure foot 26 and insert 34 are moved downwardly so that the bottom surface of the insert 34 tightly engages the top surface of the workpieces 16. Not only does this firm engagement provide stabilization of the workpieces 16, but also seals the junction 82 between the insert 34 and the workpieces 16.

After the pressure foot 26 and insert 34 have clamped the workpieces 16 to the worktable 14, the vacuum system 50 is then activated, if it has not already been activated, to provide a sub-atmospheric pressure within the working area 42. Because of the fluid seal at junction 82, substantially no air flow results through the insert 34 under the force of the vacuum, thus providing a relatively static environment within the insert 34. As indicated above, any flow of air from above the pressure foot 26 (arrow 84) does not significantly effect the air space within the insert 34. In the preferred embodiment, the flow of air 84 is at a sufficiently small rate that substantially no air flow results through the entire working area 42 when the insert 34 is in sealed engagement with the workpieces 16. After the workpieces 16 are clamped to the table, the spindle assembly 12 can then be directed downwardly so as to bring the drill bit 30 into rotating engagement with the top of the workpieces 16 for drilling purposes. Desirably, a flow of lubricant is directed into the working area 42 by way of the lubricant conduit 74, as shown by arrow 88, under the force of the lubricant pump 72 (Figure 1). Because substantially no air flow is permitted through the insert 34 while the insert is in engagement with the workpieces 16, the lubricant will accumulate in the portion of the working area 42 within the insert 34, thereby resulting in a layer of lubricant 90 accumulating around the drill bit 30 and the hole being drilled. The layer of lubricant 90 serves to cool and lubricate the working area 42 and the workpieces 16 immediately local to the hole being drilled without depositing lubricant on the balance of the workpieces 16 outside the insert 34. The lubricant 90 thus advantageously prevents the cracking and otherwise inaccurate drilling of the workpieces 16 and also eliminates the heat build-up normally associated with the drilling of hard materials, which also causes binding. It should be noted that the amount of lubricant 90 which accumulates within the working area 42 within the insert 34 depends upon the length of time of the drill stroke and the flow rate at which the lubricant is supplied. A film as thin as 1/16" is all that is required to effectively lubricate the workpieces 16 and the drill bit 30. One skilled in the art will appreciate that the flow rate at which the lubricant is supplied is variable depending upon the specific materials being machined and the rate at which the holes are being drilled. In addition to the accumulating lubricant, the drilling chips 92 generated by the drilling operation will also accumulate within the insert working area 42 for later disposal.

When the drilling operation is complete, the pressure foot 26 and insert 34 can be released from sealed engagement with the workpieces 16 as shown in Figure 3. There the pressure foot 26 is shown positioned above the workpieces 16 in between drill strokes while the work table 14 is being moved to relocate the workpieces 16. Upon release of the insert 34 from the workpieces 16, the force of the vacuum by the vacuum system (Figure 1) on the working area 42 results in a flow of air being drawn from the ambient environment 100 through the insert 34, as shown by arrows 102. The air flow 102 necessarily entrains the lubricant 90 and the drilling chips 92 (Figure 2) and directs both items into the exhaust conduit 54, as shown by arrow 104, and ultimately to the waste receptacle 56 (Figure 1). With this arrangement, no lubricant is undesirably released onto the workpieces outside the working area 42. The force of the vacuum causes almost the entire amount of lubricant to be drawn into the waste receptacle, leaving only an almost untraceable amount of lubricant behind.

Where numerous holes are required to be drilled in a single stack of workpieces in a short time period, efficiency dictates that the holes be drilled at a rapid rate. With certain drilling machines, the rate of hole drilling can reach as high as three holes per second. With such a high drilling rate, the time between drilling strokes is extremely short. Consequently, it is preferred that the lubricant be delivered to the working area 42 continuously to avoid the unrealistic practice of engaging and disengaging the lubricant supply pump (Figure 1) repeatedly in a short time period. However, where the vacuum is maintained in operation between drilling strokes, the lubricant supplied to the working area will be evacuated directly through the exhaust conduit 54 along with the flow of air 102 without spilling onto the workpiece.

It should be appreciated from the above description that the present invention overcomes the lack of effective methods for lubricating ceramic workpieces during a drilling operation and provides an easily adaptable lubrication system for conventional drilling machines. While the above description represents the preferred embodiment, the present invention may be embodied in other specific forms or practiced in other specific methods without departing from its spirit or essential characteristics. The described embodiment is to be considered in all respects only as illustrative and not restrictive. The scope of the invention is, therefore, indicated by the appended claims rather than by the foregoing description. All changes which come within the meaning and range of equivalency of the claims are to be embraced within their scope.

## Claims

1. A lubricating system for a machining apparatus, said machining apparatus being usable for the machining of at least one workpiece, said machining apparatus having a work table, a spindle assembly for supporting a machine tool, and a pressure foot for surrounding the machine tool, said pressure foot being configured so as to define a working area and to fluidly seal said working area when said pressure foot is engaged with the workpiece so as to substantially preclude fluid communication between said working area and an ambient environment, said lubricating system comprising:
a lubricant delivery system for supplying lubricant to the machining tool such that said lubricant accumulates only within said working area; and
a vacuum system for creating a vacuum within said working area, said vacuum system configured to evacuate said working area of any accumulating debris and lubricant when said pressure foot is released from engagement with the workpiece thereby permitting fluid communication between said working area and said ambient environment.

2. An improved machining apparatus having lubricating capabilities, the improved machining apparatus including a work table for supporting at least one workpiece, a spindle assembly and a pressure foot movably secured to the spindle assembly, a working area being defined by an interior surface of said pressure foot, said improved machining apparatus comprising:
a lubrication system for discharging lubricant into said working area such that lubricant supplied to said working area accumulates only within said working area when said pressure foot is engaged to the workpiece whereby said lubricant is removed from said working area when said pressure foot is released from engagement with the workpiece.

3. The device of Claim 2 further comprising an exhaust conduit and a vacuum pump for evacuating said work area of accumulating lubricant through said exhaust conduit.

4. A method of lubricating at least one workpiece during a machining operation on the workpiece by a machining apparatus, said machining apparatus comprising a work table, a spindle assembly, and a pressure foot movably secured to said spindle assembly, an interior surface of said pressure foot defining a working area around a machining tool supported by said spindle assembly, said method comprising the steps of:
creating a fluid seal about said working area by sealably engaging said pressure foot with the workpiece such that fluid communication is substantially precluded between said working area and an ambient environment;
supplying lubricant to said machining tool such that lubricant only accumulates within said working area;
creating a sub-atmospheric pressure within said working area;
eliminating said fluid seal such that fluid communication is substantially permitted between said working area and the ambient environment and
evacuating said working area of any accumulating debris so as to prevent the discharge of debris outside said working area.

5. The method of Claim 4 wherein said sub-atmospheric pressure is maintained continuously with said working area.
